# EUROPEAN PATENT APPLICATION

(11) **EP 3 029 830 A1**
(43) Date of publication of application: **08.06.2016**
(21) Application number: 14196649.9
(22) Date of filing: 05.12.2014
(51) Int. Cl.: H03F 3/26, H03H 11/32

(54) **Balun device with GFET transistors**

(71) Applicant: Centre National de la Recherche Scientifique, 75016 Paris (FR); Université des Sciences et Technologies De Lille - Lille 1, 59655 Villeneuve d'Ascq (FR); Institut Polytechnique de Bordeaux, 33402 Talence Cedex (FR); Université de Bordeaux, 33000 Bordeaux (FR)
(72) Inventor: Zimmer, Thomas, 33400 Talence (FR); Fregonese, Sébastien, 33170 Gradignan (FR); Happy, Henri, 59420 Mouvaux (FR)
(74) Representative: Brevalex

(57) **Abstract**

A Balun electronic device comprising a pair of transistors (T_{GR1}, T_{GR2}) with Graphene based layer that may have applications in high frequency systems, in particular between 1 GHz and 1 THz (figure 1).

## Description

### TECHNICAL FIELD AND PRIOR ART

The present invention generally relates to the field of electronic devices and more particularly to that of Balun devices.

It is possible to classify electronic signals into two categories: single-ended signals also called "unbalanced" and differential signals also referred as "balanced". Single ended signals are generally defined with respect to the ground whereas in a differential circuit the inputs (or output terminals) are defined as the difference between the two inputs (or output terminals, respectively).

Devices that transform single-ended signals to differential signals are commonly referred as "Balun" (for "Balanced Unbalanced").

The Balun devices are generally classified in two categories: "passive" Baluns and "active" Baluns. The passive Baluns are realized mostly using inductances, whereas active Baluns are transistor based circuits.

The drawbacks of passive Baluns are imbalance due to process variation and bulkiness. Furthermore, passive Baluns are not well adapted for very high frequencies.

An active Balun circuit that transforms a single-ended signal to differential signals and that comprises transistors made in CMOS technology is presented in document "A 2-40 GHz Active Balun Using 0.13 µm CMOS Process".

Such a circuit has a large number of transistors and is thus also bulky.

There arises the problem of implementing a new electronic device that is improved with respect to the above mentioned drawbacks.

### DISCLOSURE OF THE INVENTION

It is an objective of the present invention to provide a Balun device with reduced bulkiness. Another objective is to provide a Balun device with enhanced frequency range.

According to one embodiment, the invention provides a single-ended-to-differential conversion electronic device comprising a first transistor and a second transistor, the first transistor and the second transistor having respective gates connected together and to an input of the device on which a single-ended signal can be applied, the device further comprising :
- a first output adapted to deliver a first output signal, said first output being taken between the drain of the first transistor and the source of the first transistor,
- a second output adapted to deliver a second output signal, said second output between the drain of the second transistor and the source of the second transistor, the source of the first transistor being connected to the source of the first transistor, the first transistor and the second transistor having a channel that comprises at least a Graphene layer.

Thus, a Balun device according to an embodiment of the invention can be implemented with a pair of GFET transistors (GFET standing for Graphene Field Effect Transistors).

The first output signal and the second output signal may have equal magnitudes and a phase difference of 180°. Such symmetry is favored by the use of transistors having a Graphene channel.

To obtain optimal symmetry, the first Graphene transistor is preferably identical to the second Graphene transistor.

The device can further comprise:
- first biasing means configured to set the drain of the first transistor to a first operating potential V1,
- second biasing means configured to set the drain of the second transistor to a second operating potential V2, with V2=-V1.

First biasing means may comprise a first resistor whereas second biasing means may comprise a second resistor.

The drain of the first transistor can be connected to a first resistor, while the drain of the second transistor is connected to means forming a second resistor. First resistor is preferably equal to said second resistor.

According to a possible embodiment, the first resistor and/or the second resistor can be an active load. The active load can be implemented with at least a GFET transistor or with a transistor comprising a Graphene based channel region.

The first resistor can further be connected to a Vdd voltage supply line whereas said second resistor can further be connected to a Vss voltage supply line, with Vdd preferably equal to -Vss

The device can be adapted to deliver very high frequency output signals, i.e. between 10 GHz and to 1 THz.

### BRIEF DESCRIPTION OF THE DRAWINGS

The present invention can be better understood on reading the following description of example embodiments provided purely for indicative and non-limiting purposes, in reference to the appended drawings, in which:
Figure 1 illustrates an example of a Balun device comprising transistors with Graphene based channel ;
Figure 2A illustrates an example of a single-ended signal that may be applied to the input of a Balun device according to Figure 1 whereas Figure 2B and 2C represent differential signals that may be produced at the outputs of the Balun device according to Figure 1;
Figure 3 illustrates an example of Ids vs Vgs curves for a pair of graphene transistor that may be integrated into a Balun device according to an embodiment of the invention ;
Figure 4 illustrates an example of structure for a GFET transistor that may be integrated into a Balun device according to an embodiment of the invention ;
Figures 5A-5D illustrate electrical characteristics of a GFET transistor that may be integrated into a Balun device according to an embodiment of the invention ;
Figure 6 illustrates an example of circuit layout for a pair of GFET transistors that may be integrated into a Balun device according to an embodiment of the invention ;
Figures 7, 8, 9 illustrate examples of signals that may be produced by a Balun device according to an embodiment of the invention ;
Figure 10 illustrates another example of a Balun device comprising double gate transistors having a Graphene based channel ;
Figure 11 illustrates an alternative embodiment wherein resistors are active loads formed of transistors with a Graphene based channel ;

Identical, similar or equivalent parts of the various figures have the same numeric references for the sake of consistency between figures.

The various parts shown in the figures are not necessarily shown according to a uniform scale, so as to make the figures easier to read.

### DETAILED DESCRIPTION OF SPECIFIC EMBODIMENTS

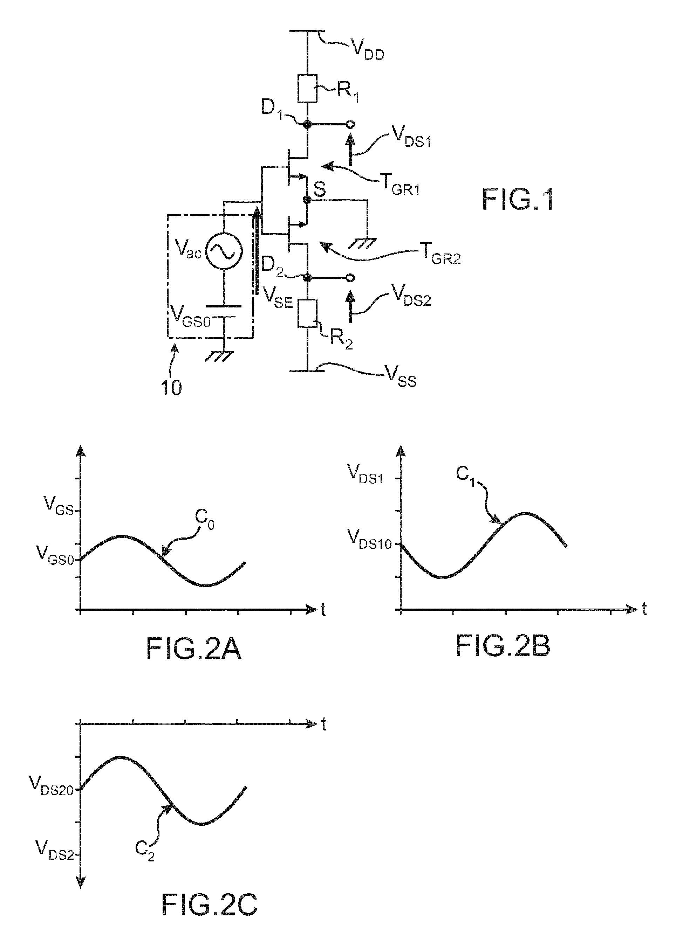

A Balun device according to an embodiment of the present invention is illustrated in Figure 1.

The Balun device is provided with a first transistor T_{GR1}, and a second transistor T_{GR2} that can be both of a GFET (GFET for Graphene Field Effect) technology type. Thus, the transistors T_{GR1}, T_{GR2} have a channel region that is formed in at least a Graphene layer. This device is configured to transform a single-ended signal vse into differential signals vds1, vds2 that are symmetrical, i.e. with same magnitude but in phase opposition. Hence, transistors T_{GR1}, T_{GR2} are arranged and biased so that they have opposite transconductances, i.e. of same value but with opposite signs.

Transistors T_{GR1}, T_{GR2} have respective gates that are connected to each other and respective sources that are also connected to each other. In this example, the common source S is connected to the ground (GND).

The common gate G serves as an input to which the single ended AC signal Vse is applied. An example of single ended sinusoidal signal that is produced by generator 10 at the input of the device of figure 1 is given via a curve C₀ on figure 2A.

Differential signals vds1, vds2 are produced respectively at a first output taken between the drain D1 and the source S of the first transistor T_{GR1}, and at a second output taken between the drain D2 and the source S of the second transistor T_{GR2}. Examples of differential signals vds1, vds2 produced by the Balun device are given respectively via the curve C₁ of figure 2B and the curve C₂ of figure 2C. The output signals vds1, vds2 of the Balun device are such that: vds1 = A* vgs, vds2 = -A* vgs.

In order to provide differential signals vds1, vds2 that are symmetrical, i.e. with same magnitude and a phase difference of the order of 180°, the transistors T_{GR1}, T_{GR2} are preferably identical but may be biased differently in particular with opposite potentials applied to their respective drains D₁, D₂ by first biasing means and second biasing means.

Graphene transistors T_{GR1}, T_{GR2} are particularly favorable to the production of differential signals vds1, vds2 having good symmetry to the extent that they have good conduction properties both for holes and electrons.

The first biasing means may comprise a first resistor R₁ having a terminal connected to the drain D₁ of the first transistor T_{GR1}, and another terminal connected to a second biasing line that is supplying a Vdd potential for example of the order of 1 Volt. The second biasing means may comprise a second resistor R₂ connected to the drain D₂ of the second transistor T_{GR2}, and a second biasing line to apply a Vss potential for example of the order of -1 Volt. The first resistor R₁ and the second resistor R₂ are preferably identical and for example of the order of 50 Ω.

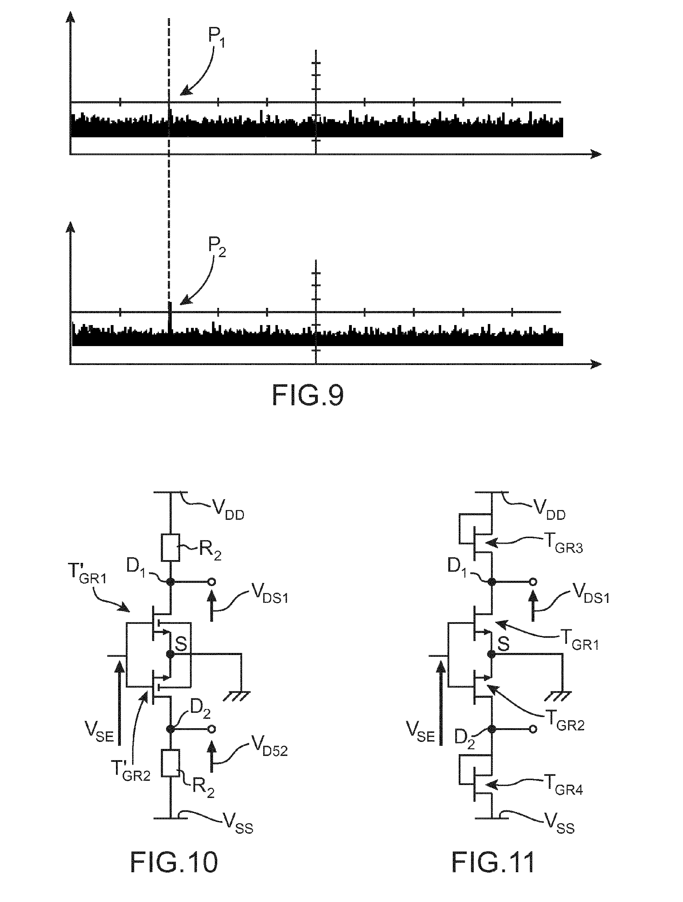

According to a possible specific embodiment illustrated in figure 11, the first resistor and the second resistor may be active loads formed respectively by GFET transistors T_{GR3}, T_{GR4} having a gate connected to its drain.

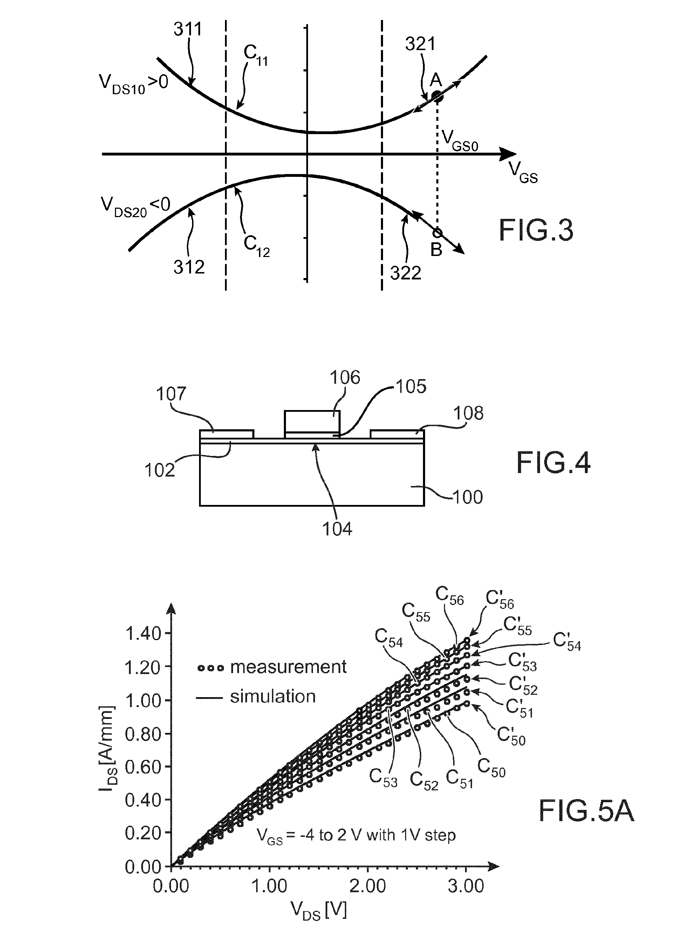

Figure 3 represents drain current (Ids) versus gate-source voltage (Vgs) characteristics of a Graphene transistor that is identical to the transistors T_{GR1}, T_{GR2} of the device according to figure 1, respectively for a first positive drain-source voltage V_{DS10} (curve C₁₁), and for a negative drain-source voltage V_{DS20} (curve C₁₂). With a positive drain-source voltage, a positive drain current is obtained whereas with a drain-source voltage that is negative (V_{DS20} < 0), a negative drain current is produced.

The current-voltage curve C₁₁ is a first parabola-like with a stationary point (minimum) at V_{GS} ≈ V_{DS10/}2, while the current-voltage curve C₁₂ is a second parabola symmetric with the first parabola and with a second stationary point (maximum) at V_{GS} ≈ V_{DS20}/2.

When choosing an operating point at V_{GS} = V_{GSO} and V_{DS} = V_{DS10} (point A on figure 3) for the first transistor T_{GR1}, one can see that if an AC signal is further applied on the common gate (e.g. signal according to figure 2A), Ids increases during the positive phase and decreases during the negative phase. As a result, the voltage drop over R₁ increases during positive phase and decreases during the negative phase (e.g. signal according to figure 2B).

When choosing an operating point at V_{GS}=V_{GSO} and V_{DS}=V_{DS20} (point B on figure 3) for the second transistor T_{GR2}, one can see that when an AC-signal is further applied on the common gate G, the current gets more negative for the positive half cycle, resulting in an increased voltage drop over R₂ and less negative in the negative half cycle given a reduced voltage drop over R₂ (e.g. signal according to figure 2C).

To further improve the symmetric behavior of the Balun device, the operating points A, B are preferably points with same Vgso value that are chosen in areas of the biasing symmetric curves Ids = f(Vgs) having high slopes or slopes higher than 0.05 mS/mm. In figure 3, such areas are indicated by references 311 and 321 of the curve C₁₁ or 312 and 322 of the curve C₁₂, i.e. areas outside the region between the dashed lines.

An example of structure of a graphene transistor T_{GR1} or T_{GR2} that is integrated in a circuit as above described is given in Figure 4.

The transistor comprises a channel region 104 that is provided in at least one or several Graphene layer(s), preferably less than 5 or 3 layers. More preferably the channel region where the charge carrier circulate is a single layer 102 of Graphene. This layer 102 is lying on a substrate 100 that may, for example, be made of SiC. Opposite the channel region 104, a gate dielectric zone 105 and a top gate electrode 106 formed on this dielectric zone 105 rest on the Graphene layer 102. The gate dielectric zone 105 can be made for example of Al₂O₃ with a thickness for example of about 8 nm. The top gate electrode 106 can be made of a metal such as for example Ni or Au, or a stack of metal layers e.g. a stack of Ni and Au. The top gate length can be of in the order of several nanometers or several micrometers, e.g. of 150 nm.

Metallic drain contact 107 and source contact 108 are positioned either side of the top gate electrode 106. The metallic source and drain contacts 107, 108 may for example be made of the same metal layer or the same stack of metal layers as the top gate, for example of Ni or Au or a stack of Ni with a thickness for example of about 50 nm and Au with a thickness for example of about 300 nm.

An alternative transistor structure (not represented) with a back gate structure may further be provided. In such alternative structure, the source and drain contacts 107, 108 are situated on a first side of the Graphene layer whereas the gate which is the called "back gate" is situated on another side of the Graphene layer opposite said first side.

To form such transistor, a gate material is formed on a substrate. Such gate material can for example be Al. An upper part of this back gate can then be oxidized to form a gate dielectric, for example Al₂O₃ based. Then, the Graphene layer in which the channel region is provided is deposited on the gate dielectric.

Figures 5A to 5D provide a comparison between measured electrical characteristics (dotted line curves C') and simulated electric characteristics (solid line curves C) of a Graphene transistor as described in connection with FIG 4.

In Figure 5A, the measurement curves C₅₁, C₅₂, C₅₃, C₅₄, C₅₅, C₅₆, C₅₇, (or corresponding simulation curves C'₅₁, C'₅₂, C'₅₃, C'₅₄, C'₅₅, C'₅₆, C'₅₇) illustrate drain/source current versus drain/source voltage characteristics of the graphene transistor with respective gate source voltages of -4V, -3V, -2V, -1V, 0V, +1V, +2V.

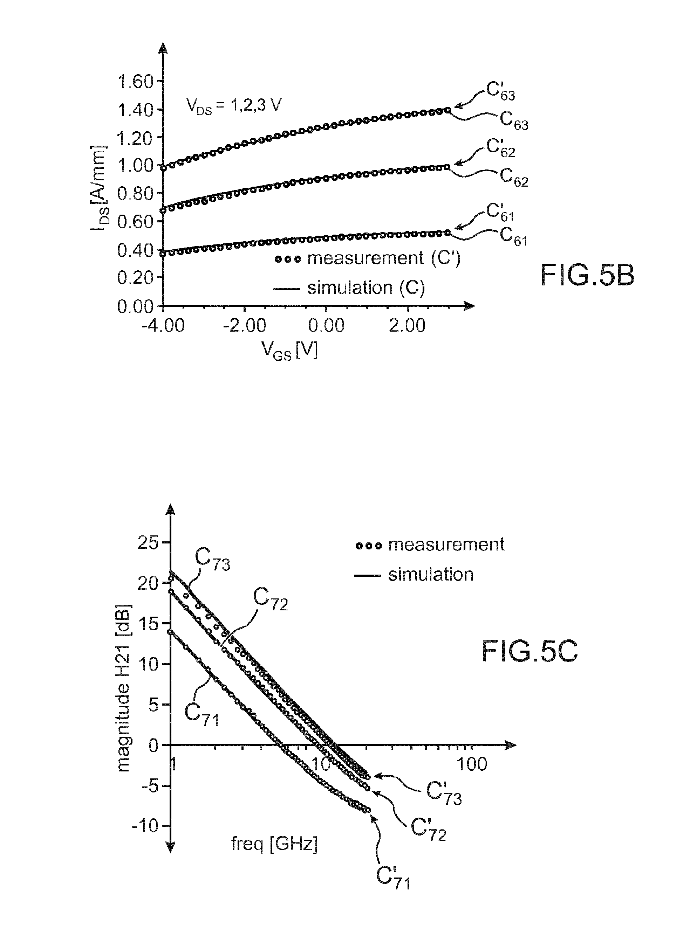

In Figure 5B, the measurement curves C₆₁, C₆₂, C₆₃, (or corresponding simulation curves C'₆₁, C'₆₂, C'₆₃) illustrate the drain/source current versus gate/source voltage characteristics of the Graphene transistor for respective drain/source voltages of +1V, +2V, +3V.

In Figure 5C curves C₇₁, C₇₂, C₇₃, (or corresponding simulation curves C'₇₁, C'₇₂, C'₇₃) illustrate current gain h₂₁ versus frequency characteristics of the Graphene transistor for gate-source voltage -3 volts and for respective drain-source voltages of +1V, +2V, +3V.

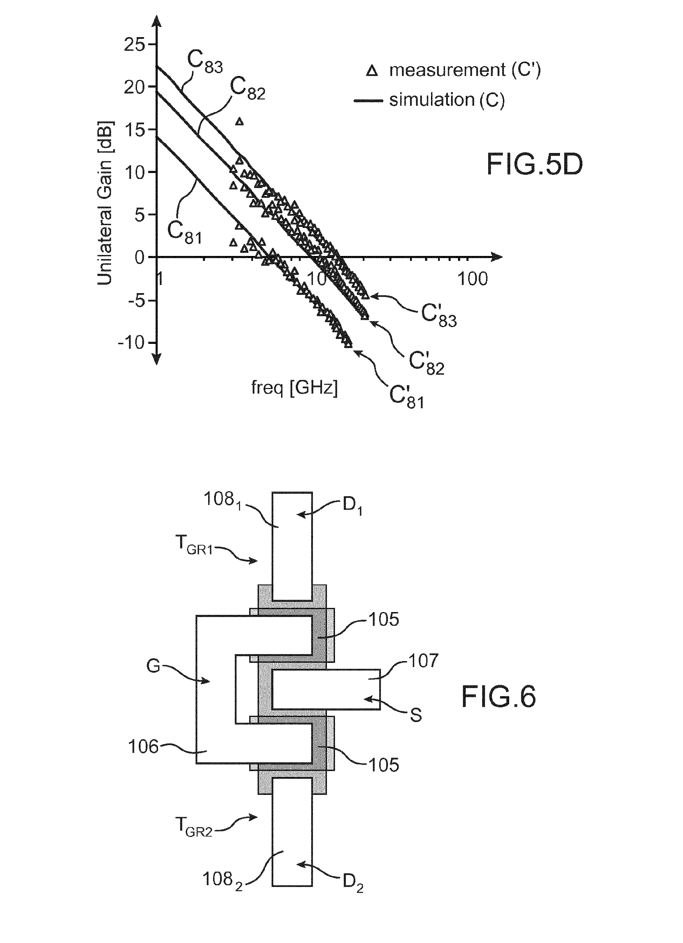

In Figure 5D, curves C₈₁, C₈₂, C₈₃ , (or corresponding simulation curves C'₈₁, C'₈₂, C'₈₃) illustrate unilateral gain versus frequency characteristics of the Graphene transistor for gate- source voltage equal to -3V and for respective drain-source voltages of +1V, +2V, +3V.

Figures 5C and 5D show that with such a graphene transistor, Cutoff Frequency f_{τ} (i.e. frequency at which the magnitude of the short circuit current gain h21 rolls off to 0 dB) and maximum frequency of oscillation fmax (i.e. frequency at which the unilateral power gain rolls off to 0 dB) may be close to 10 GHz. A Balun circuit as described above is thus adapted to operate at very high frequency, in particular up to 10 GHz. A working frequency up to 1 Thz can be attained.

Transistors with a structure such as described in relation with figure 4 and that are integrated in a Balun circuit as described in relation with figure 1, can be arranged in a layout such as that according to figure 6. Other layouts may also be implemented.

In this Figure 6, a top view is showing a common source S contact 107, a common gate G contact 106 partially surrounding the common source S. When different metal layers are available, the contact can be formed above the source. The respective drain 108₁, 108₂ of the transistors T_{GR1}, T_{GR2} arranged on each side of the common gate contact 106.

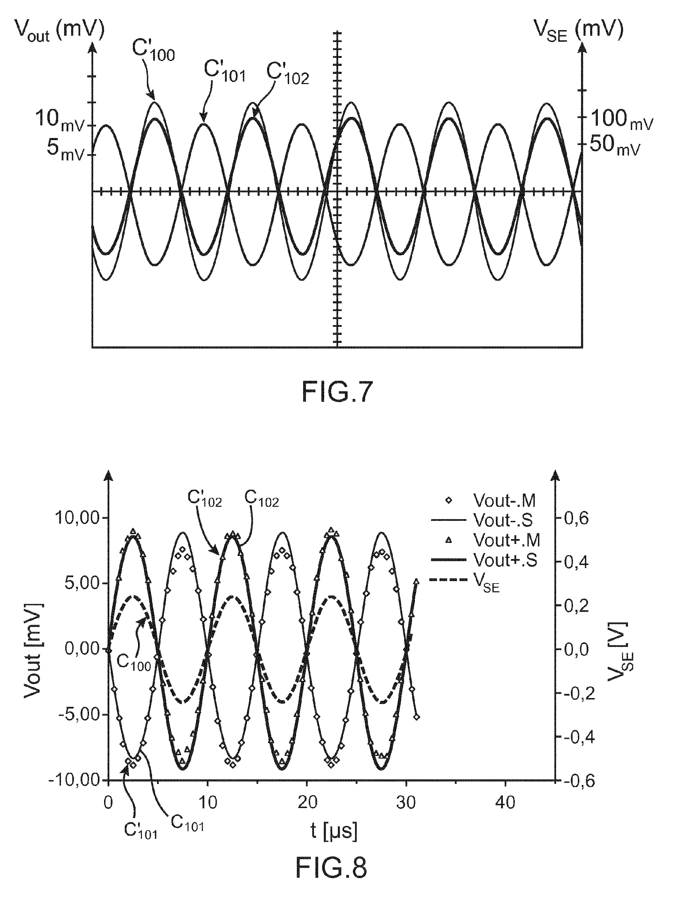

The good symmetrical behavior (same magnitude and phase difference close to 180°) of output signals provided by a Balun circuit having such an arrangement is shown by experimental results of Figures 7, 8, and 9.

In Figure 7, the input signal applied on common gate is represented by a curve C'₁₀₀ (with dashed line in figure 8) whereas curves C'₁₀₁ and C'₁₀₂ are respectively representative of a first output signal measured between first drain and common source and of a second output signal measured between second drain and common source. The measured output signals match output signals obtained by simulation and are represented in figure 8 (continuous line curves C₁₀₁ and C₁₀₂). Such simulated output signals can be obtained by "Advanced Design System" (ADS) simulation software from Keysight Technologies. It can be further seen from the peaks P1 and P2 in Figure 9 representing fast Fourier transform of the first output and of the second output that the signal quality of the output signals is very high. The FFT results indicate that almost no harmonics can be identified, whereas both output signals are well-matched to one another.

In Figure 10, another Balun device is illustrated. For this embodiment, the transistors T_{GR1}, T_{GR2} are here replaced by GFET transistors T'_{GR1}, T'_{GR2} with a double gate structure. Thus, each transistor T'_{GR1}, T'_{GR2} has two gate electrodes. A first gate electrode of transistor T'_{GR1} is connected to a first gate electrode of transistor T'_{GR2} whereas a second gate electrode of transistor T'_{GR1} and a second gate electrode of transistor T'_{GR2} are also connected to each other and to the ground (GND).

A Balun circuit with Graphene transistors such as above described may have many applications, in particular in emerging Radio Frequency (RF), Millimeter-Wave (MMW) and TeraHertz (THz) devices such as: 77GHz/120GHz automotive radars, MMW Imaging and Sensing, fast measurement equipment, 60 GHz wireless networking fast downloading Rx/Tx, 400Gbit/s optical data communications, 4G photonic mobile communication, transceivers, RF wireless communication devices, two-way satellite communication systems.

## Claims

1. A single-ended-to-differential conversion electronic device comprising a first transistor (T_{GR1}) and a second transistor (T_{GR2}), the first transistor (T_{GR1}) and the second transistor (T_{GR2}) having respective gates connected together and to an input of the device on which a single-ended signal is applied, the device further comprising :
- a first output adapted to deliver a first output signal, said first output being taken between a drain of the first transistor and a source of the first transistor,
- a second output adapted to deliver a second output signal, said second output being taken between a drain of the second transistor and a source of the second transistor, the source of the second transistor further being connected to the source of the first transistor,
The first transistor and the second transistor having a channel that comprises at least a Graphene layer.

2. The electronic device according to claim 1, wherein the first signal and the second signal have same equal magnitudes and a phase difference of 180°.

3. The electronic device according to claim 1 or 2 further comprising:
- first biasing circuit comprising a first resistor R1, the first biasing means being configured to set the drain of the first transistor to a first operating potential V1,
- second biasing circuit comprising a second resistor R2, the second biasing means being configured to set the drain of the second transistor to a second operating potential V2, with V2=-V1.

4. The electronic device according to any of the claims 1 to 3, wherein the drain of the first transistor is connected to a first resistor (R1), the drain of the second transistor being connected to a second resistor (R2), said first resistor and said second resistor being equal.

5. The electronic device according to claim 4, wherein the first resistor (R1) is connected to a Vdd voltage supply line, the second resistor (R2), being further connected to a Vss voltage supply line, with Vdd=-Vss.

6. The electronic device according to any of claims 3 to 5, the first resistor R1 and/or the second resistor R2 being an active load, said active load comprising a transistor with a Graphene based channel layer.

7. The electronic device according to any of the claims 1 to 6, wherein the first transistor is identical to said second transistor.

8. The electronic device according to any of the claims 1 to 7, the device being configured to deliver very high frequency output signals, i.e. up to 1 THz.
